# EUROPEAN PATENT APPLICATION

(11) **EP 1 605 075 A1**
(43) Date of publication of application: **14.12.2005**
(21) Application number: 04708028.8
(22) Date of filing: 04.02.2004
(51) Int. Cl.: C23C 16/44

(54) **SEMICONDUCTOR PROCESSING METHOD FOR PROCESSING SUBSTRATE TO BE PROCESSED AND ITS APPARATUS**

(30) Priority: 07.02.2003 JP 2003031504
(71) Applicant: TOKYO ELECTRON LIMITED, Minato-ku, Tokyo 107-8481 (JP)
(72) Inventor: FURUYA, Haruhikoc/o Intellectual Property Departm, Tokyo 107 8481 (JP); MOROZUMI, Yuichiro c/o Intellectual Property Depar, Tokyo 107-8481 (JP); IKEGAWA, Hiroaki c/o Intellectual Property Departm, Tokyo 107-8481 (JP); HIRAYAMA, Makoto c/o Intellectual Property Depatme, Tokyo 107-8481 (JP); ITO, Yuichi c/o Intellectual Property Department, Tokyo 107-8484 (JP)
(74) Representative: Gleiss, Alf-Olav
(86) International application number: PCT/JP2004/001125
(87) International publication number: WO 2004/070079

(57) **Abstract**

A method for processing a target substrate (10) in a semiconductor processing apparatus (1) controls temperature of a first substrate (10) at a process temperature inside a process container (2), while supplying a process gas into the process container, thereby subjecting the first substrate to a semiconductor process, during which a by-product film is formed inside the process container. After the semiconductor process and unload of the first substrate (10) out of the process container (2), a reforming gas is supplied into the process container, thereby subjecting the by-product film to a reformation process, which is set to reduce thermal reflectivity of the by-product film. After the reformation process, temperature of a second substrate (10) is controlled at the process temperature inside the process container (2), while supplying the process gas into the process container, thereby subjecting the second substrate to the semiconductor process.

## Description

### Technical Field

The present invention relates to a semiconductor processing method and apparatus for processing a target substrate, and particularly to a processing technique for preventing a by-product film, which is formed on the inner surface of a process container during a semiconductor process, from interfering with temperature control during the semiconductor process. The term "semiconductor process" used herein includes various kinds of processes which are performed to manufacture a semiconductor device or a structure having wiring layers, electrodes, and the like to be connected to a semiconductor device, on a target substrate, such as a semiconductor wafer or a glass substrate used for an LCD (Liquid Crystal Display) or FPD (Flat Panel Display), by forming semiconductor layers, insulating layers, and conductive layers in predetermined patterns on the target substrate.

### Background Art

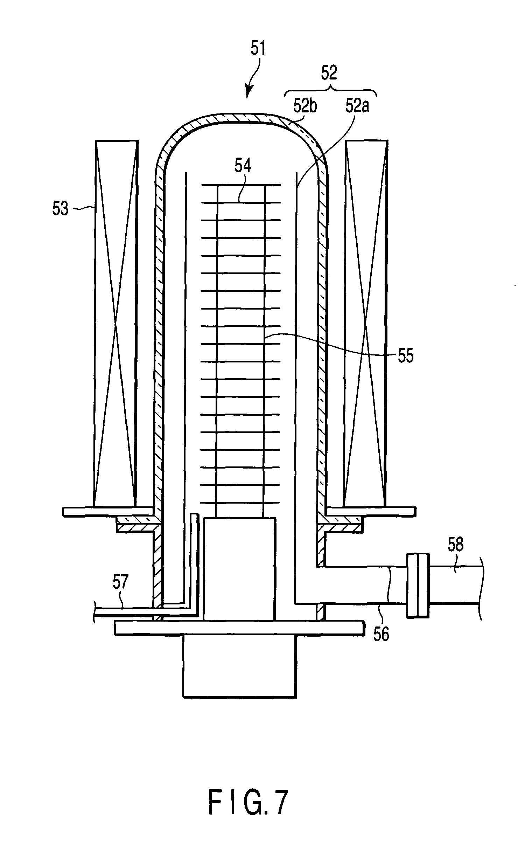

In manufacturing semiconductor devices, a film-formation process is performed by, e.g., CVD (Chemical Vapor Deposition) to form a thin film on a target substrate, such as a semiconductor wafer. A vertical heat-processing apparatus is known as an apparatus of the batch type that performs a film-formation process of this kind on a plurality of wafers all together. FIG. 7 is a view showing a conventional vertical heat-processing apparatus.

When a process is performed in the heat-processing apparatus shown in FIG. 7, the interior of a process container 52, which has a double-tube structure formed of an inner tube 52a and an outer tube 52b, is first preheated by a heater 53. Then, a wafer boat 55 holding a plurality of wafers 54 is loaded into the process container 52 (into the inner tube 52a). Then, gas inside the process container 52 is exhausted through an exhaust port 56 to reduce the pressure inside the process container 52 to a predetermined pressure. Also, the interior of the process container 52 is heated to a predetermined temperature by the heater 53.

After the process container 52 is set at the predetermined pressure, a process gas is supplied through a gas feed line 57 into the inner tube 52a. The process gas supplied into the inner tube 52a causes a thermal reaction. Reaction products produced by the thermal reaction are deposited on the surface of the wafers 54, so a thin film is formed on the surface of the wafers 54.

Exhaust gas generated by the film-formation process is exhausted through an exhaust line 58 connected to an exhaust port 56 out of the process container 52. The exhaust line 58 is provided with a trap, a scrubber, and so forth (not shown) disposed thereon. The exhaust gas is rid of reaction products or the like contained therein by the trap and so forth, so that the gas is detoxified and then exhausted out of the process container

Reaction products produced by the film-formation process are deposited not only on the surface of the wafers 54, but they are also deposited or stick onto, e.g., the inner surface of the inner tube 52a, thereby forming a by-product film. If the film-formation process is continued inside the process container 52 with the by-product film deposited inside, the by-product film tends to peel off and generate particles. The particles are deposited on the wafers 54, which reduces the yield of the semiconductor devices manufactured.

Accordingly, the heat-processing apparatus 51 requires a cleaning process for the process container 52, after the film-formation process is repeated a plurality of times, and before particles are generated. In the cleaning process, the interior of the process container 52 is heated up to a predetermined temperature by the heater 53, and a cleaning gas is supplied into the process container 52. The by-product film deposited inside the process container 52 is etched by the cleaning gas, and removed out of the process container 52.

However, the present inventors have found that conventional processing methods of this kind allow by-product films to remarkably affect temperature control during a semiconductor process, as described later.

### Disclosure of Invention

An object of the present invention is to provide a semiconductor processing method and apparatus for processing a target substrate, which prevent a by-product film formed on the inner surface of a process container from affecting temperature control during a semiconductor process.

According to a first aspect of the present invention, there is provided a method for processing a target substrate in a semiconductor processing apparatus, the method comprising:
controlling temperature of a first substrate to be at a process temperature inside a process container, while supplying a process gas into the process container, thereby subjecting the first substrate to a semiconductor process, during which a by-product film is formed on an inner surface of the process container;
subsequently to the semiconductor process and unload of the first substrate out of the process container, supplying a reforming gas into the process container, thereby subjecting the by-product film to a reformation process, which is set to reduce thermal reflectivity of the by-product film; and
subsequently to the reformation process, controlling temperature of a second substrate to be at the process temperature inside the process container, while supplying the process gas into the process container, thereby subjecting the second substrate to the semiconductor process.

According to a second aspect of the present invention, there is provided a method for processing a target substrate in a semiconductor processing apparatus, the method comprising:
controlling temperature of a first substrate to be at a process temperature inside a process container, while supplying a process gas into the process container, thereby forming a thin film containing a metal nitride as a main component on the first substrate by a CVD process, during which a by-product film containing a metal nitride as a main component is formed on an inner surface of the process container;
subsequently to the CVD process and unload of the first substrate out of the process container, supplying a reforming gas into the process container, thereby subjecting the by-product film to a reformation process, which is set to oxidizes the by-product film with the reforming gas at a reforming temperature sufficiently higher than the process temperature, so as to reduce thermal reflectivity of the by-product film; and
subsequently to the reformation process, controlling temperature of a second substrate to be at the process temperature inside the process container, while supplying the process gas into the process container, thereby forming a thin film on the second substrate by the CVD process.

According to a third aspect of the present invention, there is provided a semiconductor processing apparatus comprising;
a process container configured to accommodate a target substrate;
a heater configured to heat the target substrate accommodated in the process container;
a gas supply section configured to supply a necessary gas into the process container; and
a control section configured to control the heater and the gas supply section,
wherein the control section is preset to execute
controlling temperature of a first substrate to be at a process temperature inside the process container, while supplying a process gas into the process container, thereby subjecting the first substrate to a semiconductor process, during which a by-product film is formed on an inner surface of the process container;
subsequently to the semiconductor process and unload of the first substrate out of the process container, supplying a reforming gas into the process container, thereby subjecting the by-product film to a reformation process, which is set to reduce thermal reflectivity of the by-product film; and
subsequently to the reformation process, controlling temperature of a second substrate to be at the process temperature inside the process container, while supplying the process gas into the process container, thereby subjecting the second substrate to the semiconductor process.

### Brief Description of Drawings

FIG. 1 is a sectional view showing a vertical heat-processing apparatus (vertical CVD apparatus) according to an embodiment of the present invention;
FIG. 2 is a view showing a recipe (time sequence) used in control on a processing method according to an embodiment of the present invention;
FIG. 3 is a graph showing the relationship between the position inside a process container and temperature, obtained by an experiment 1 performed in the apparatus shown in FIG. 1;
FIG. 4 is a graph showing the relationship between the heating time and temperature, obtained by an experiment 2 performed in the apparatus shown in FIG. 1;
FIG. 5 is a graph showing the relationship between the position inside a process container and the thickness of a titanium nitride film on wafers, obtained by an experiment 3 performed in the apparatus shown in FIG. 1;
FIG. 6 is a graph showing the relationship between the position inside a process container and planar uniformity in the thickness of a titanium nitride film on wafers, obtained by an experiment performed in the apparatus shown in FIG. 1; and
FIG. 7 is a view showing a conventional vertical heat-processing apparatus.

### Best Mode for Carrying Out the Invention

In the process of developing the present invention, the inventors studied conventional methods for processing a target substrate in semiconductor processing apparatuses, in relation to their problems. As a result, the inventors have arrived at the findings given below.

As described above, where a predetermined thin film is formed on semiconductor wafers 54 by CVD in the heat-processing apparatus 51 shown in FIG. 7, a by-product film is non-uniformly formed on the inner surface of the inner tube 52a and so forth. Where a thin film having a high thermal reflectivity, such as a titanium nitride film, is to be formed, a by-product film comes to also have a high thermal reflectivity. Since the semiconductor wafers 54 in the process container 52 are heated by the heater 53 disposed around the process container 52, if a film with a high thermal reflectivity is non-uniformly present between the wafers 54 and heater 53, uniformity of both heat supply from the heater 53 and heat discharge from the semiconductor wafers 54 is greatly affected. As a consequence, the heater 53 cannot accurately control the temperature of the wafers 54, with unevenness in the temperature inside the process container 52.

If the controllability on the temperature inside the process container 52 (the temperature of the wafers 54) decreases during film-formation, it becomes difficult to form a predetermined thin film on the wafers 54 with high accuracy. Particularly, the state of a by-product film changes with the number of repetitions of a CVD process, and the reproducibility of film-formation between lots of wafers lowers, depending on the state of the by-product film. If a cleaning process for the process container 52 is performed frequently to remove the by-product film, the reproducibility of film-formation can be prevented from lowering, but the productivity rate decreases in return.

In light of this, the present inventors have adopted a method of lowering the thermal reflectivity of a by-product film to prevent temperature control by the heater 53 from deteriorating. The thermal reflectivity of a by-product film can be reduced by supplying a reforming gas into the process container 52 between semiconductor process periods to reform the by-product film. According to this method, unlike cleaning processes, the reproducibility of film-formation can be prevented from lowering, without greatly decreasing the productivity rate.

In apparatuses of the hot wall type, such as the heat-processing apparatus 51 shown in FIG. 7, the thermal reflectivity of a by-product film can be determined by the color of the film. In general, where the color of the film is deep, such as brown, the thermal reflectivity is high, and as the color of the film is closer to white or transparent, the thermal reflectivity decreases. For example, a titanium nitride film is auburn (a color between purple and brown), and therefore has a high thermal reflectivity, while a titanium oxide film is white, and therefore has a low thermal reflectivity.

Provided that the thermal reflectivity of a by-product film is the reciprocal of light transmission (in other words, thermal reflectivity ≒ light reflectivity), the relationship between the light transmission of the by-product film and temperature controllability can be digitalized. Specifically, where the light transmission of a by-product film is 50% or less, the temperature controllability is very low, but where it is 70% or more, and preferably 90% or more, the decrease in temperature controllability can be within a permissible range (for infrared light with a wavelength of 3 to 4 µm).

From another view point, it is preferable for a by-product film thus reformed to have a light transmission not much lower than the light transmission of the inner tube 52a and outer tube 52b of the process container 52, and especially of the inner tube 52a, (a member interposed between the wafers 54 and heater 53, on which a by-product film is formed). For example, where the inner tube 52a of the process container 52 is made of quartz, which is a common material used for this purpose, the light transmission of the inner tube 52a is about 70 to 90%. Accordingly, if a by-product film is reformed such that the light transmission of the inner tube 52a with the by-product film deposited thereon remains within this range, good temperature controllability is maintained.

This problem, in which a by-product film formed on the inner surface of a process container affects temperature control during a semiconductor process, is not limited to a CVD apparatus, but is common to other semiconductor processing apparatuses, such as an etching apparatus.

Embodiments of the present invention achieved on the basis of the findings given above will now be described with reference to the accompanying drawings. In the following description, the constituent elements having substantially the same function and arrangement are denoted by the same reference numerals, and a repetitive description will be made only when necessary.

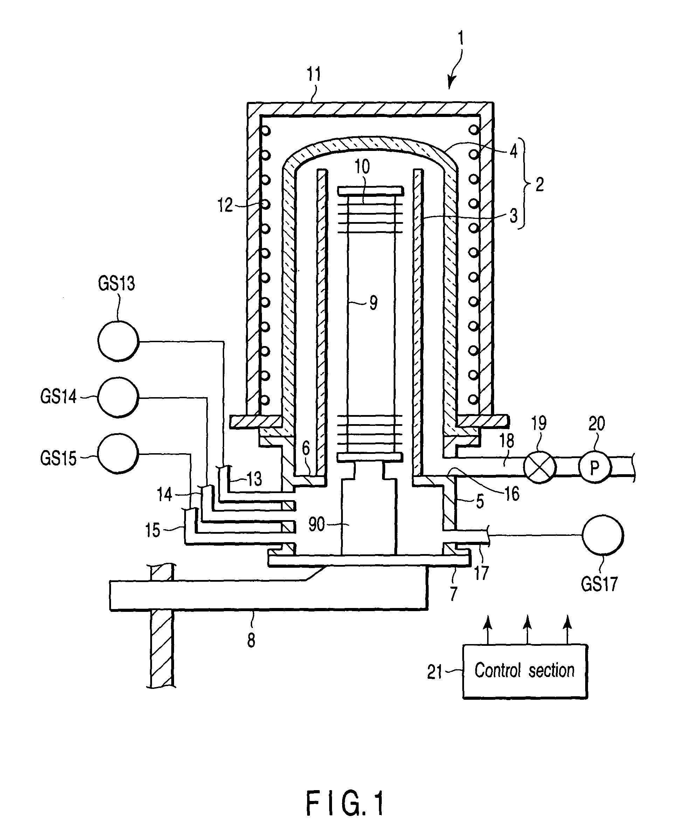

FIG. 1 is a sectional view showing a vertical heat-processing apparatus (vertical CVD apparatus) according to an embodiment of the present invention. The heat-processing apparatus 1 includes a process container 2, which is essentially cylindrical with a longitudinal direction directed in the vertical direction. The process container 2 has a double-tube structure formed of an inner tube 3 and an outer tube 4 having a closed top, wherein the an outer tube 4 covers the inner tube 3 with a constant gap interposed therebetween. The inner tube 3 and outer tube 4 are formed of a heat-resistant material, such as quartz.

A cylindrical manifold 5 made of stainless steel (SUS) is disposed below the outer tube 4. The manifold 5 is airtightly connected to the bottom of the outer tube 4. The inner tube 3 is supported by a support ring 6, which is integrally formed with the manifold 5 and extends from the inner wall of the manifold 5.

The manifold 5 is engaged with a lid 7 disposed therebelow, which is moved up and down by a boat elevator 8. When the lid 7 is moved by the boat elevator 8, the bottom opening of the manifold 5 (the load port of the process container 2) is closed.

A wafer boat 9 made of, e.g., quartz is placed on the lid 7 through a heat-insulating cylinder 90. The wafer boat 9 is arranged to support a plurality of target substrates, such as semiconductor wafers 10, at predetermined intervals in the vertical direction.

A heat-insulating structure 11 is disposed to surround the process container 2. The heat-insulating structure 11 is provided with a heater 12, such as a resistance heating body, which is disposed on the inner wall of the structure 11 and is used to raise the temperature. The interior of the process container 2 is heated to a predetermined temperature by the heater 12, so that the wafers 10 are heated to a predetermined temperature. Thus, the heat-processing apparatus 1 is provided with a heating mechanism of a hot wall type (indirect heating type) that heats up the interior of a process container 2 to heat wafers 10.

A first process gas feed line 13 and a second process gas feed line 14, which are used for feeding process gases, and a reforming gas feed line 15 for feeding a reforming gas are inserted through the sidewall of the manifold 5. The gas feed lines 13, 14, and 15 are respectively opened at the bottom region inside the inner tube 3. For example, as shown in FIG. 1, the gas feed lines 13, 14, and 15 are inserted through the sidewall of the manifold 5 at positions below the support ring 6 (below the inner tube 3).

The process gas feed lines 13 and 14 are respectively connected to first and second gas supply sections GS13 and GS14 each through, e.g., a mass-flow controller (not shown). In this embodiment, the first gas supply section GS13 is a section for supplying a first process gas containing ammonia (NH₃) gas. The second gas supply section GS14 is a section for supplying a second process gas containing titanium tetrachloride (TiCl₄) gas. Accordingly, the heat-processing apparatus 1 uses the first and second process gases to perform a CVD process, thereby forming a thin film of titanium nitride on the wafers 10.

The reforming gas feed line 15 is connected to a reforming gas supply section GS15 through, e.g., a mass-flow controller (not shown). In this embodiment, the reforming gas is an oxidizing gas arranged to oxidize a by-product film containing titanium nitride as the main component (i.e., 50% or more), which has been deposited on the inner surface of the process container 2, and especially of the inner tube 3. For example, this oxidizing gas may be oxygen or ozone gas. In the case of oxygen gas, oxygen gas to be supplied may be turned into plasma outside or inside the process container 2, so that the wafers 10 are supplied with oxygen radicals.

As described above, according to this embodiment, the first process gas feed line 13 supplies the first process gas containing ammonia gas, the second process gas feed line 13 supplies the second process gas containing titanium tetrachloride gas, and the third process gas feed line 15 supplies an oxidizing gas used as a reforming gas, respectively into the inner tube 3 of the process container 2. Each of the first and second process gases and reforming gas is mixed with a suitable amount of a carrier gas as needed, but such a carrier gas will not be mentioned for the sake of simplicity of explanation in the following description.

An exhaust port 16 is formed in the sidewall of the manifold 5. The exhaust port 16 is formed above the support ring 6, and communicates with the space formed between the inner tube 3 and outer tube 4 of the process container 2. The exhaust gas or the like generated inside the inner tube 3 is exhausted through the space formed between the inner tube 3 and outer tube 4 to the exhaust port 16. A purge gas supply section GS17 for supplying nitrogen gas as a purge gas is connected thorough a gas feed line 17 to the sidewall of the manifold 5 below the exhaust port 16.

The exhaust port 16 is airtightly connected to an exhaust line 18. The exhaust line 18 is provided with a valve 19 and a vacuum pump 20 disposed thereon in this order from the upstream side. The valve 19 adjusts the opening ratio of the exhaust line 18 to control the pressure inside the process container 2 to be a predetermined pressure. The vacuum pump 20 exhausts gas inside the process container 2 through the exhaust line 18, and thereby adjust the pressure inside the process container 2.

The exhaust line 18 is provided with a trap, a scrubber, and so forth (not shown) disposed thereon. The exhaust gas is rid of reaction products or the like contained therein by the trap and so forth, so that the gas is detoxified and then exhausted out of the process container 2.

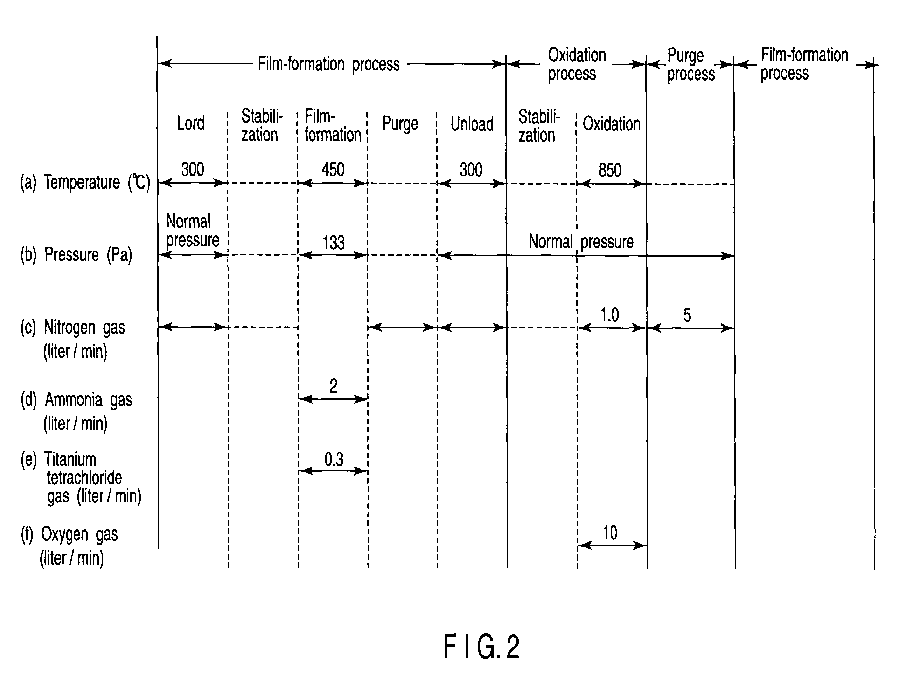

The boat elevator 8, heater 12, gas supply sections GS13, GS14, GS15, and GS17, valve 19, and vacuum pump 20 are connected to a control section 21. The control section 21 is formed of a CPU including a microprocessor, a process controller, and so forth. The control section 21 is arranged to measure temperatures and pressures at respective portions of the heat-processing apparatus 1, and then output control signals or the like to the portions based on the measurement data to control them. FIG. 2 is a view showing a recipe (time sequence) used in control on a processing method according to an embodiment of the present invention.

Next, an explanation will be give of a method of processing semiconductor wafers 10 in the heat-processing apparatus 1 described above. This embodiment is exemplified by a case where a titanium nitride film is formed on the wafers 10, with reference to the recipe shown in FIG. 2. The operations described below of respective portions of the heat-processing apparatus 1 are controlled by the control section 21.

This processing method according to an embodiment of the present invention comprises a film-formation process of forming a titanium nitride film on the wafers 10, a reformation process of reforming a by-product film deposited on the inner surface of the process container 2 and containing titanium nitride as the main component (i.e., 50% or more), and a purge process of exhausting gas inside the process container 2.

First, in order to perform the film-formation process, the interior of the process container 2 is heated by the heater 12 to a predetermined load temperature of, e.g., 300°C in this example, as shown in FIG. 2, (a). On the other hand, the wafer boat 9 holding wafers 10 is placed on the lid 7 having been moved down by the boat elevator 8. Then, while a predetermined amount of nitrogen gas is supplied through the gas feed line 17 into the process container 2, the lid 7 is moved up by the boat elevator 8 to load the wafer boat 9 into the process container 2. As a consequence, the wafers 10 are accommodated in the inner tube 3 of the process container 2, and the process container 2 is airtightly closed (load step).

After the process container 2 is airtightly closed, a predetermined amount of nitrogen gas is supplied through the gas feed line 17 into the process container 2. At the same time, the opening ratio of the valve 19 is adjusted, and the vacuum pump 20 is driven to exhaust gas inside the process container 2, thereby starting pressure reduction of the process container 2. The interior of the process container 2 is kept exhausted until the pressure inside the process container 2 is reduced to a predetermined pressure of, e.g., 26.6 to 2660 Pa (0.2 to 20 Torr), such as 133 Pa (1 Torr) in this example, as shown in FIG. 2, (b). Further, the interior of the process container 2 is heated up by the heater 12 to a predetermined temperature of, e.g., 300 to 600°C, such as 450°C in this example, as shown in FIG. 2, (a). These pressure reduction and heating up operations are performed until the process container 2 is stabilized at the predetermined pressure and temperature (stabilization step).

After the interior of the process container 2 is stabilized at the predetermined pressure and temperature, supply of nitrogen gas through the gas feed line 17 is stopped. Then, the first process gas containing ammonia gas and the second process gas containing titanium tetrachloride gas are supplied respectively through the process gas feed lines 13 and 14 into the inner tube 3. The flow rate of ammonia gas is set at, e.g., 1.5 to 3.5 liters/min, such as 2 liters/min in this example, as shown in FIG. 2, (d). The flow rate of titanium tetrachloride gas is set at, e.g., 0.25 to 0.35 liters/min, such as 0.3 liters/min in this example, as shown in FIG. 2, (e).

The ammonia and titanium tetrachloride thus supplied into the inner tube 3 cause a thermal decomposition reaction due to heat inside the process container. With this reaction, titanium nitride is deposited on the surface of the wafers 10, thus a titanium nitride film is formed on the wafers 10 (film-formation step).

After a titanium nitride film with a predetermined thickness is formed on the wafers 10, supplies of the first and second process gases through the process gas feed lines 13 and 14 are stopped. Then, the opening ratio of the valve 19 is adjusted, and the vacuum pump 20 is driven to exhaust gas inside the process container 2. Further, a predetermined amount of nitrogen gas is supplied through the gas feed line 17 to exhaust gas inside the process container 2 to exhaust line 18 (purge step). In this case, the gas exhaust and nitrogen gas supply for the interior of the process container 2 are preferably repeated a plurality of times to reliably exhaust gas inside the process container 2.

Finally, a predetermined amount of nitrogen gas is supplied through the gas feed line 17 to return the interior of the process container 2 to normal pressure. Then, the lid 7 is moved down by the boat elevator 8, thus the wafer boat 9 (wafers 10) is unloaded from the process container 2 (unload step).

After the film-formation process described above, a non-uniform deposition of a by-product film, which contains titanium nitride as the main component and therefore has a high thermal reflectivity, is present on parts of the process container 2, such as the inner tube 3 and outer tube 4, heat-insulating cylinder 90, wafer boat 9, and dummy wafers (wafers placed in the wafer boat 9 not as product wafers, but for improving the process performance), and especially on the inner surface of the inner tube 3. If a subsequent lot of wafers are subjected to a film-formation process under this condition, uniformity of both heat supply from the heater 12 and heat discharge from the semiconductor wafers 10 is greatly affected. As a consequence, the heater 12 cannot accurately control the temperature of the wafers 10, with unevenness in the temperature inside the process container 2.

In consideration of this, a reformation process is performed after the film-formation process, to reduce the thermal reflectivity of the by-product film, so that the temperature inside the process container 2 can be controlled to be uniform. In the reformation process, a predetermined amount of nitrogen gas is first supplied through the gas feed line 17 into the process container 2. Under this state, the lid 7 is moved up by the boat elevator 8 to load the wafer boat 9 with no product wafers 10 placed therein (however, dummy wafers are placed) into the process container 2. As a consequence, the wafer boat 9 is accommodated in the inner tube 3 of the process container 2, and the process container 2 is airtightly closed.

Then, a predetermined amount of nitrogen gas is supplied through the gas feed line 17 into the process container 2. Further, the interior of the process container 2 is heated up by the heater 12 to a predetermined temperature of, e.g., 800 to 1000°C, such as 850°C in this example, as shown in FIG. 2, (a). These pressure reduction and heating up operations are performed until the process container 2 is stabilized at the predetermined pressure and temperature (stabilization step).

Then, a predetermined amount of nitrogen gas is supplied through the gas feed line 17 into the process container 2, i.e., into the inner tube 3, at a flow rate of e.g., 0.1 liters/min in this example, as shown in FIG. 2, (c). Further, a predetermined amount of oxygen gas is supplied through the reforming gas feed line 15 into the process container 2, i.e., into the inner tube 3, at a flow rate of e.g., 10 liters/min in this example, as shown in FIG. 2, (f).

The oxygen thus supplied into the inner tube 3 is activated by heat inside the process container 2, and oxidizes the by-product film deposited inside the process container 2 and containing titanium nitride as the main component. As a consequence, the by-product film is reformed into a film containing titanium oxide as the main component. The titanium nitride film is auburn (a color between purple and brown), and therefore has a high thermal reflectivity (low light transmission). By contrast, the titanium oxide film is white, and therefore has a low thermal reflectivity (high light transmission). As described previously, in apparatuses of the hot wall type, the thermal reflectivity of a by-product film is high where the color of the film is deep, such as brown, and the thermal reflectivity decreases as the color of the film is closer to white or transparent.

Accordingly, even if a subsequent lot of wafers are subjected to a film-formation process under a state where the by-product film thus reformed is present inside the process container 2, uniformity of heat supply from the heater 12 and heat discharge from the semiconductor wafers 10 is not greatly affected. As a consequence, the heater 12 can accurately control the temperature of the wafers 10, while maintaining a highly uniform heat region in the process container 2.

Then, a purge process is performed after the reformation process. More specifically, after supply of oxygen gas through the reforming gas feed line 15 is stopped, the opening ratio of the valve 19 is adjusted, and the vacuum pump 20 is driven to exhaust gas inside the process container 2. Further, a predetermined amount of nitrogen gas is supplied through the gas feed line 17 at a flow rate of e.g., 5 liters/min in this example, as shown in FIG. 2, (c), to exhaust gas inside the process container 2 to the exhaust line 18.

Then, a subsequent lot of wafers are subjected to the film-formation process, oxidation process, and purge process in this order, in the same manner as described above. The operations described above are repeated, i.e., the film-formation process, oxidation process, and purge process described above are repeatedly performed for a plurality of lots of wafers, so as to sequentially perform several units of the film-formation process of a titanium nitride film. As a consequence, the reproducibility of film-formation is prevented from deteriorating while maintaining the productivity rate.

It should be noted that, since by-product films deposited during respective units of the film-formation process are accumulated inside the process container 2, it is preferable to perform a cleaning process after the film-formation process, oxidation process, and purge process are repeated a plurality of times, and before particles are generated. In the cleaning process, the interior of the process container 2 is heated up by the heater 12 to a predetermined temperature, and a cleaning gas is supplied into the process container 2. The by-product film deposited inside the process container 2 is etched by the cleaning gas and removed out of the process container 2.

### [Experiments]

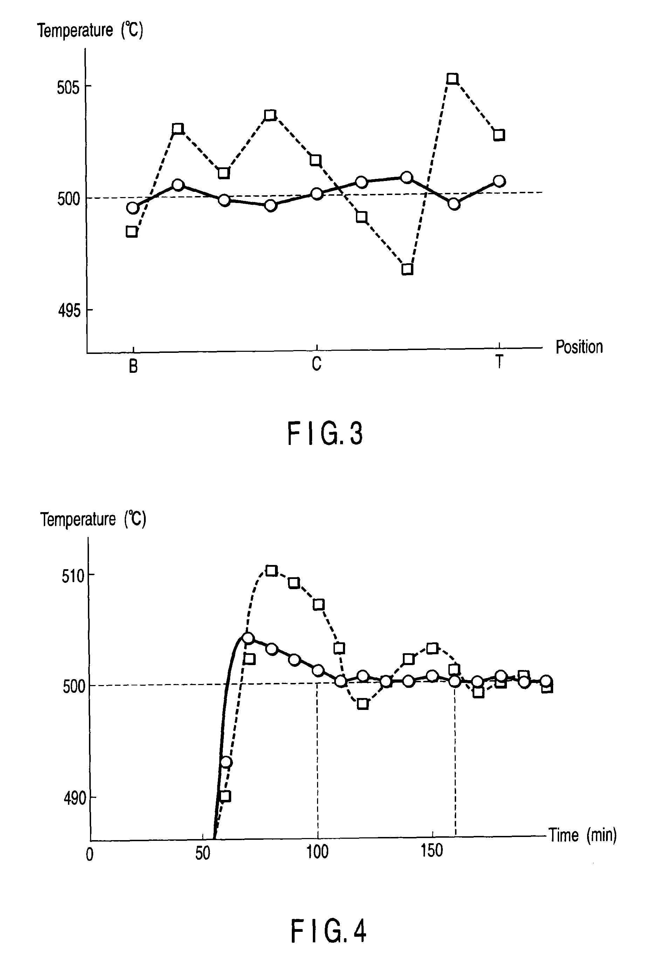

In order to examine some effects of this embodiment, experiments were conducted to form a titanium nitride film on wafers 10, using the heat-processing apparatus 1 shown in FIG. 1. FIGS. 3 to 6 are graphs showing data obtained by these experiments.

In FIGS. 3 to 6, the symbol "○" represents cases where a titanium nitride film was formed on wafers 10 by a processing method of a present example according to the embodiment of the present invention. Specifically, in these cases, the film-formation process was performed under a state where the by-product film deposited inside the process container 2 contained titanium oxide as the main component. On the other hand, the symbol "□" represents cases where a titanium nitride film was formed on wafers 10 by a processing method of a comparative example according to an conventional technique. Specifically, in these cases, the film-formation process was performed under a state where the by-product film deposited inside the process container 2 contained titanium nitride as the main component.

In an experiment 1, an examination was performed on the relationship between the position inside the process container 2 and temperature, where the interior of the process container 2 with a by-product film deposited therein was heated up to 500°C. FIG. 3 is a graph showing the relationship between the position inside the process container and temperature, obtained by an experiment 1. In FIG. 3, the symbol B denotes the bottom of the process container 2, the symbol C denotes the center of the process container 2, and the symbol T denotes the top of the process container 2.

As shown in FIG. 3, the processing method of the present example 1 (indicated with the symbol "○") showed the temperature inside the process container 2 being slightly shifted from 500°C as a whole. On the other hand, the processing method of the comparative example 1 (indicated with the symbol "□") showed the temperature inside the process container 2 being remarkably shifted from 500°C with a large deviation especially at the top (T) of the process container 2. This large deviation was due to the fact that a by-product film was apt to be more deposited at the top of the process container 2.

In an experiment 2, an examination was performed on the relationship between the heating time and the temperature inside the process container 2, where the interior of the process container 2 with a by-product film deposited therein was heated up to 500°C. FIG. 4 is a graph showing the relationship between the heating time and temperature, obtained by an experiment 2 performed in the apparatus shown in FIG. 1.

As shown in FIG. 4, the processing method of the present example 2 (indicated with the symbol "○") showed the temperature inside the process container 2 becoming almost uniform in a shorter period of time, as compared with the processing method of the comparative example 2 (indicated with the symbol "□"). For example, the time when the temperature inside the process container 2 falls in a range of 500°C±1°C may be used as a reference as to whether the temperature inside the process container 2 becomes uniform. In accordance with this reference, the processing method of the present example 2 took about 100 minutes to control the interior of the process container 2 to be a uniform temperature. On the other hand, the processing method of the comparative example 2 took about 160 minutes to control the interior of the process container 2 to be a uniform temperature.

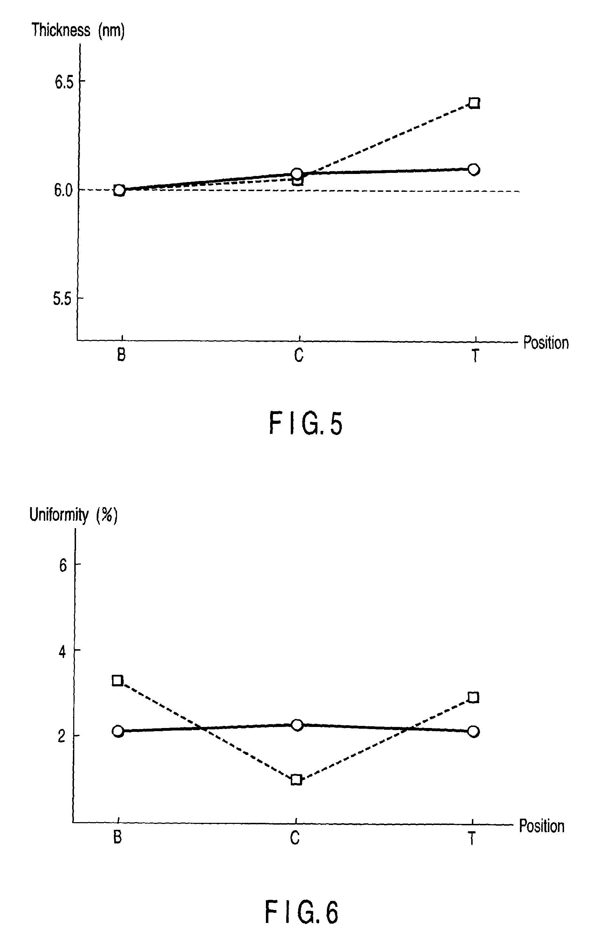

In an experiment 3, a titanium nitride film of 6 nm was formed on wafers 10 at a process temperature of 500°C, and an examination was performed on the relationship between the position inside the process container 2 and the film thickness and planar uniformity of the titanium nitride film on the wafers 10. FIG. 5 is a graph showing the relationship between the position inside the process container and the thickness of a titanium nitride film on wafers, obtained by the experiment 3. FIG. 6 is a graph showing the relationship between the position inside the process container and planar uniformity in the thickness of a titanium nitride film on wafers, obtained by the experiment 3. In FIGS. 5 and 6, the symbol B denotes the bottom of the process container 2, the symbol C denotes the center of the process container 2, and the symbol T denotes the top of the process container 2.

As shown in FIG. 5, the processing method of the present example 3 (indicated with the symbol "○") enabled a titanium nitride film to be formed on the wafers 10 with almost the same film thickness at the three positions of the process container 2. This is thought to have resulted from the fact that the interior of the process container 2 was controlled at an essentially uniform temperature over the entire region from the bottom to the top. On the other hand, the processing method of the comparative example 3 (indicated with the symbol "□") caused a titanium nitride film formed at the top (T) of the process container 2 to have a film thickness far larger than 6 nm. This is thought to occur because a by-product film containing titanium nitride as the main component was more deposited at the top of the process container 2, thereby making temperature unstable.

Further, as shown in FIG. 6, the processing method of the present example 3 (indicated with the symbol "○") allowed a titanium nitride film to be formed on the wafers 10 with almost the same planar uniformity at the three positions of the process container 2. This is thought to have resulted from the fact that the interior of the process container 2 was controlled at an essentially uniform temperature over the entire region from the bottom to the top. On the other hand, the processing method of the comparative example 3 (indicated with the symbol "□") caused a titanium nitride film formed on the wafer 10 to have different values of the planar uniformity, depending on the position inside the process container 2. This is thought to occur because there were fluctuations in the temperature inside the process container 2.

As has been described with reference to FIGS. 3 to 6, it has been confirmed by the experiments 1 to 3 that the processing method according to the embodiment of the present invention has the following advantages. Specifically, during a film-formation process, the interior of a process container can be controlled at an essentially uniform temperature over the entire region from the bottom to the top. Accordingly, before a film-formation process starts, the interior of a process container can be set at a certain temperature in a short period of time. A thin film can be formed on target substrates by a film-formation process to have a predetermined thickness without fluctuations depending on the position inside a process container. Further, a thin film can be formed on target substrates by a film-formation process to have a predetermined planar uniformity without fluctuations depending on the position inside a process container.

In the embodiment described above, a by-product film deposited inside the process container 2 and containing titanium nitride as the main component is oxidized and thereby reformed to a film containing titanium oxide as the main component. As a consequence, the thermal reflectivity of the by-product film decreases, and controllability of the temperature inside the process container 2 is less affected by the by-product film. However, the embodiment described above may be variously modified or applied within the scope of the present invention.

For example, the process of reforming a by-product film may be a process other than an oxidation process, as long as it can reduce the thermal reflectivity of the by-product film. The composition of a by-product film may be a composition other than that containing titanium nitride as the main component, as long as the thermal reflectivity thereof can decrease by a reformation process. The color of a by-product film obtained by reformation may be a color other than white or transparent, as long as the thermal reflectivity thereof can be reduced.

The metal-containing gas used in a CVD process is not limited to titanium tetrachloride (TiCl₄), and it may be another halogenated metal, such as TiF₄, TiI₄, or TaCl₄. The other reaction gas used in a CVD process is not limited to ammonia (NH₃), and it may be another gas containing N and H, such as a mixture gas of N₂ and H₂, or a hydrazine gas, e.g., MMH.

The by-product film is not limited to a film containing the reaction product of a film-formation process, such as CVD, as the main component, and it may contain a reaction by-product of a film-formation process or a reaction by-product of another semiconductor process. For example, the problem such as a by-product film formed on the inner surface of a process container affecting temperature control during a semiconductor process is not limited to a CVD apparatus, but is common to other semiconductor processing apparatuses, such as an etching apparatus.

As shown in FIG. 2, in the embodiment described above, the film-formation process, reformation process, and purge process are repeated in this order. However, a reformation process may be performed after a semiconductor process is repeated a plurality of times without any reformation process interposed therebetween. However, in this case, the number of repetitions of a semiconductor process performed without a reformation process needs to be set within a range in which the temperature inside a process container does not become unstable due to a by-product film.

As shown in FIG. 1, in the embodiment described above, nitrogen gas is supplied through the gas feed line 17 into the process container 2. However, nitrogen gas may be also supplied through the process gas feed lines 13 and 14. In this case, nitrogen gas is supplied into the process container 2 from several positions, and gas inside the process container 2 is therefore effectively exhausted with nitrogen gas.

Further, as shown in FIG. 1, in the embodiment described above, the semiconductor processing apparatus is exemplified by a vertical heat-processing apparatus of the batch type with the process container 2 having a double-tube structure, which is formed of the inner tube 3 and outer tube 4. However, the present invention may be applied to a heat-processing apparatus of the batch type with a process container having a single-tube structure, from which the inner tube 3 is excluded. Alternatively, the present invention may be applied to a processing apparatus of the single-substrate type arranged to process target substrates one by one.

As regards a target substrate, other than a semiconductor wafer, the present invention may also be applied to a glass substrate or LCD substrate.

### Industrial Applicability

According to the present invention, there is provided a semiconductor processing method and apparatus for processing a target substrate, which prevent a by-product film formed on the inner surface of a process container from affecting temperature control during a semiconductor process.

## Claims

1. A method for processing a target substrate in a semiconductor processing apparatus, the method comprising:
controlling temperature of a first substrate to be at a process temperature inside a process container, while supplying a process gas into the process container, thereby subjecting the first substrate to a semiconductor process, during which a by-product film is formed on an inner surface of the process container;
subsequently to the semiconductor process and unload of the first substrate out of the process container, supplying a reforming gas into the process container, thereby subjecting the by-product film to a reformation process, which is set to reduce thermal reflectivity of the by-product film; and
subsequently to the reformation process, controlling temperature of a second substrate to be at the process temperature inside the process container, while supplying the process gas into the process container, thereby subjecting the second substrate to the semiconductor process.

2. The method according to claim 1, wherein the reformation process is set to change color of the by-product film to white or transparent.

3. The method according to claim 1, wherein the reformation process is set to change light transmission of the by-product film to be 70% or more.

4. The method according to claim 1, wherein the by-product film containing a metal nitride as a main component.

5. The method according to claim 4, wherein the metal nitride is titanium nitride.

6. The method according to claim 4, wherein the reforming gas is a gas that oxidizes the by-product film.

7. The method according to claim 6, wherein the reforming gas comprises oxygen, oxygen radicals, or ozone.

8. The method according to claim 6, wherein the reformation process is performed at a reforming temperature sufficiently higher than the process temperature.

9. The method according to claim 1, wherein the reformation process and the semiconductor process are alternately repeated.

10. The method according to claim 1, wherein the reformation process is performed after the semiconductor process is repeated a plurality of times without the reformation process.

11. The method according to claim 1, wherein the semiconductor process is a process for forming a thin film on a target substrate by a CVD process.

12. A method for processing a target substrate in a semiconductor processing apparatus, the method comprising:
controlling temperature of a first substrate to be at a process temperature inside a process container, while supplying a process gas into the process container, thereby forming a thin film containing a metal nitride as a main component on the first substrate by a CVD process, during which a by-product film containing a metal nitride as a main component is formed on an inner surface of the process container;
subsequently to the CVD process and unload of the first substrate out of the process container, supplying a reforming gas into the process container, thereby subjecting the by-product film to a reformation process, which is set to oxidizes the by-product film with the reforming gas at a reforming temperature sufficiently higher than the process temperature, so as to reduce thermal reflectivity of the by-product film; and
subsequently to the reformation process, controlling temperature of a second substrate to be at the process temperature inside the process container, while supplying the process gas into the process container, thereby forming a thin film on the second substrate by the CVD process.

13. The method according to claim 12, wherein the reforming gas comprises oxygen, oxygen radicals, or ozone.

14. The method according to claim 12, wherein the process gas comprises a halogenated metal gas, and a gas containing N and H.

15. The method according to claim 14, wherein the halogenated metal gas is titanium tetrachloride.

16. The method according to claim 14, wherein the gas containing N and H is ammonia.

17. The method according to claim 12, wherein the process container is configured to accommodate a plurality of target substrates at intervals in a vertical direction, the target substrates are heated by a heater disposed around the process container, and the by-product film is present between the target substrates and the heater.

18. A semiconductor processing apparatus comprising;
a process container configured to accommodate a target substrate;
a heater configured to heat the target substrate accommodated in the process container;
a gas supply section configured to supply a necessary gas into the process container; and
a control section configured to control the heater and the gas supply section,
wherein the control section is preset to execute
controlling temperature of a first substrate to be at a process temperature inside the process container, while supplying a process gas into the process container, thereby subjecting the first substrate to a semiconductor process, during which a by-product film is formed on an inner surface of the process container;
subsequently to the semiconductor process and unload of the first substrate out of the process container, supplying a reforming gas into the process container, thereby subjecting the by-product film to a reformation process, which is set to reduce thermal reflectivity of the by-product film; and
subsequently to the reformation process, controlling temperature of a second substrate to be at the process temperature inside the process container, while supplying the process gas into the process container, thereby subjecting the second substrate to the semiconductor process.
